(19) European Patent Office — Europäisches Patentamt — Office européen des brevets

(11) **EP 1 094 516 A2**

(12) **EUROPEAN PATENT APPLICATION**

(43) Date of publication:
25.04.2001 Bulletin 2001/17

(51) Int. Cl.⁷: **H01L 23/373**

(21) Application number: **00122624.0**

(22) Date of filing: **17.10.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **20.10.1999 JP 29761899**

(71) Applicants:
- **Fuji Polymer Industries Co., Ltd.**
  **Nagoya-shi, Aichi-ken 460-0012 (JP)**
- **SHOWA ALUMINUM CORPORATION**
  **Sakai-shi Osaka 590-8576 (JP)**

(72) Inventors:
- **Hirata, Katsuhiko,**
  **Fuji Polymer Ind. Co. Ltd.**
  **Nishikamo-gun, Aichi 470-0533 (JP)**
- **Matsukura, Hiroshi,**
  **Fuji Polymer Ind. Co. Ltd.**
  **Nishikamo-gun, Aichi 470-0533 (JP)**
- **Ushioda, Shunta**
  **Yuuki-shi, Ibaragi 307-0001 (JP)**
- **Fukui, Koichiro**
  **Oyama-shi, Tochigi 323-0811 (JP)**

(74) Representative:
**Paul, Dieter-Alfred, Dipl.-Ing. et al**
**Fichtestrasse 18**
**41464 Neuss (DE)**

(54) **Thermally conductive composition and method of forming thermally conductive film with use of same**

(57) A thermally conductive composition comprises 100 parts by weight of a wax, 0 to 1000 parts by weight of a tackifier and 10 to 1200 parts by weight of a thermally conductive filler, and is a gel at room temperature or a sol at a high temperature of 35 to 100° C and is reversibly convertible in state. The composition is used for forming a thermally conductive film on a heat sink for use in electronic devices for releasing the heat generated by an electronic component of the device. Since the composition is in the form of a gel at room temperature, the thermally conductive film formed from the composition is unlikely to peel off easily, rendering the heat sink having the film formed thereon easy to handle. The film of the composition is converted to a sol with the heat generated by the electronic component in use, therefore completely fills up the clearance between the electronic component and the heat sink and becomes thinner, consequently diminishing the thermal resistance between the heat-generating electronic component and the heat sink and ensuring heat transfer from the component to the heat sink with an improved efficiency.

**Fig.1**

**Description**

BACKGROUND OF THE INVENTION

The present invention relates to thermally conductive compositions useful for forming thermally conductive films on heat sinks for use in electronic devices, such as personal computers and servers, for releasing the heat generated by an electronic component of the device, and a method of forming the thermally conductive film using the composition.

For example, personal computers have a packaged integrated circuit (electronic component), such as a central processing unit (CPU), mounted on a printed circuit board which is termed a "motherboard." With remarkable progress in giving personal computers an increased number of functions and a higher processing speed in recent years, the CPU is increased in output and therefore generates an increased quantity of heat. Accordingly it is practice to dispose a heat sink in contact with the CPU and fix the heat sink to the motherboard in this state. Various expedients are devised to reduce the contact thermal resistance due to the presence of an air layer between the CPU and the heat sink and to thereby improve the transfer of heat from the CPU to the heat sink.

One of these expedients is to apply a thermally conductive grease to the portion of the heat sink to be held in contact with the CPU. However, the grease must be applied usually manually and has the problem of necessitating cumbersome work. Moreover, the coating of grease is removable easily, so that until the heat sink coated with the grease by its manufacturer is transported to the personal computer manufacturer and fixed to the motherboard, it is likely that the grease will be removed, failing to achieve the desired improvement in thermal conductivity and permitting the removed grease to adhere to other components. The coated heat sink therefore needs to be handled with care. To prevent the removal of grease, there is a need to cover the grease coating with a protective sheet, hence a cumbersome procedure.

Another example of expedients is to use a heat dissipating insulating sheet which is prepared from a reticular reinforcing material by coating the material with a silicone rubber having a thermally conductive filler incorporated therein and curing the rubber, in combination with an uncured liquid silicone rubber having a thermally conductive filler incorporated therein to obtain a composite thermally conductive sheet by forming and curing the liquid silicone rubber. The conductive sheet is affixed to the heat sink (see, for example, JP-A No. 155517/1994). However, owing to the presence of air between the heat sink and the thermally conductive sheet when the sheet is affixed to the heat sink, a small clearance remains between the CPU and the heat sink, producing relatively great thermal resistance between the CPU and the heat sink. The thermal resistance varies from assembly to assembly.

SUMMARY OF THE INVENTION

An object of the present invention is to overcome the foregoing problems and to provide a thermally conductive composition for forming on a heat sink a thermally conductive film which is easy to form and not readily removable and which serves to diminish the thermal resistance between a heat-generating electronic component and the heat sink, with reduced variations in the thermal resistance from assembly to assembly, and a method of forming the thermally conductive film with use of the composition.

The present invention provides a thermally conductive composition for forming a thermally conductive film on a heat sink for use in an electronic device for releasing the heat generated by an electronic component of the device, the composition comprising 100 parts by weight of a thermoplastic resin, 1 to 1500 parts by weight of a wax or softener, 0 to 1000 parts by weight of a tackifier and 10 to 1200 parts by weight of a thermally conductive filler, the composition being a gel at room temperature or a sol at a high temperature of 35 to 100° C and being reversibly convertible in state.

The present invention provides another thermally conductive composition for forming a thermally conductive film on a heat sink for use in an electronic device for releasing the heat generated by an electronic component of the device, the composition comprising 100 parts by weight of a rubber, 1 to 1500 parts by weight of a wax or softener, 0 to 1000 parts by weight of a tackifier and 10 to 1200 parts by weight of a thermally conductive filler, the composition being a gel at room temperature or a sol at a high temperature of 35 to 100° C and being reversibly convertible in state.

The present invention provides still another thermally conductive composition for forming a thermally conductive film on a heat sink for use in an electronic device for releasing the heat generated by an electronic component of the device, the composition comprising 100 parts by weight of a wax, 0 to 1000 parts by weight of a tackifier and 10 to 1200 parts by weight of a thermally conductive filler, the composition being a gel at room temperature or a sol at a high temperature of 35 to 100° C and being reversibly convertible in state.

Since the thermally conductive composition of the invention is in the form of a gel at room temperature, the thermally conductive film formed from the composition is unlikely to peel off easily, rendering the heat sink having the film formed thereon easy to handle. The film of the composition is converted to a sol with the heat generated by the electronic component during heat generation, therefore completely fills up the clearance between the electronic component and the heat sink and becomes thinner, consequently diminishing the thermal resistance between the heat-generating electronic component and the heat sink and ensuring heat transfer from the component to the heat sink with an improved efficiency.

The present invention also provides a method of forming a thermally conductive film which method is characterized in that a sol comprising any one of the thermally conductive compositions of the invention is applied by printing to the portion of a heat sink to be brought into contact with an electronic component and is thereafter converted to a gel.

According to the thermally conductive film forming method of the invention, the sol comprising one of the compositions is applied by printing to the portion of a heat sink to be brought into contact with an electronic component, so that the sol can be applied with ease and will not be readily removed upon gelation, rendering the coated heat sink easy to handle. Moreover, the film formed will not vary in thickness from sink to sink, and no air is present between the film formed and the heat sink, consequently diminishing variations in the thermal resistance between the heat-generating electronic component and the heat sink and permitting heat transfer from the component to the heat sink with an improved efficiency.

According to the thermally conductive film forming method of the invention, it is desirable that the film to be formed be 15 to 150 μm in thickness. If the film thickness is less than 15 μm, the thermally conductive composition encounters difficulties in penetrating into minute cavities or indentations in the surfaces of the heat sink and the heat-generating electronic component, failing to effectively diminish the thermal resistance. If the thickness is in excess of 150 μm, increased thermal resistance will result. More preferably, the film thickness is 25 to 100 μm.

BRIEF DESCRIPTION OF THE DRAWINGS

FIG. 1 is a perspective view showing a heat sink having a thermally conductive film formed thereon with use of a thermally conductive composition of the invention; and
FIG. 2 is a front view showing an evaluation test method.

DESCRIPTION OF THE PREFERRED EMBODIMENTS

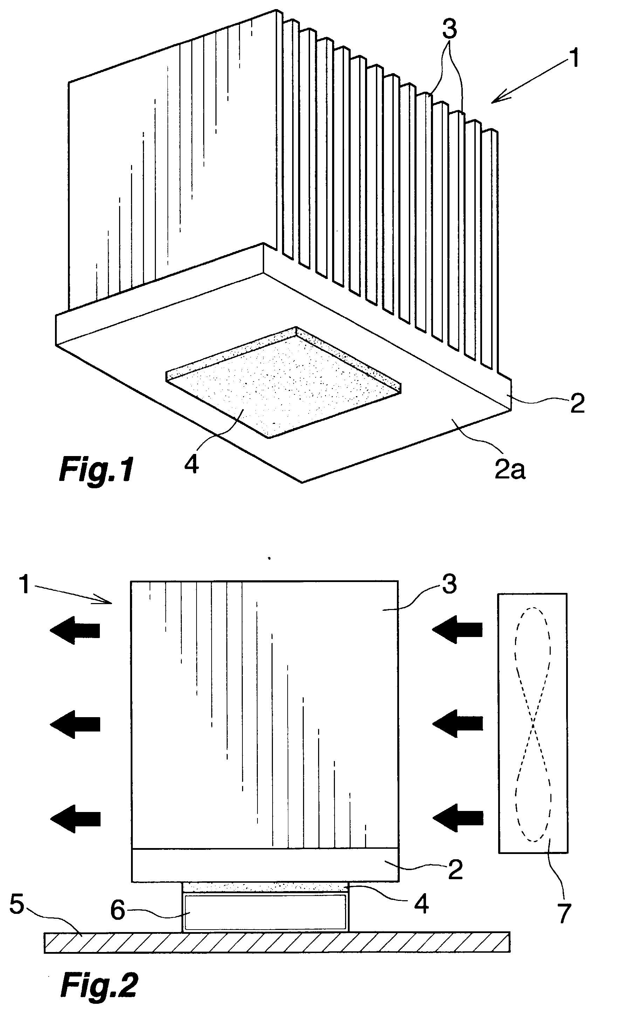

With reference to FIG. 1, a heat sink 1 is made of an extrudate of aluminum (including an aluminum alloy) and comprises a rectangular plate body 2 having one surface which is flat as at 2a, and a plurality of radiating plate fins 3 formed in parallel on the other surface of the plate body 2 integrally therewith and extending widthwise thereof. A sol comprising a thermally conductive composition is printed on the flat surface 2a, which is the portion of the heat sink 1 to be held in contact with an electronic component, and converted to a gel to form a thermally conductive film 4.

Examples of useful thermally conductive compositions are of the following three types.

(1) A composition comprising 100 parts by weight of a thermoplastic resin, 1 to 1500 parts by weight of a wax or softener, 0 to 1000 parts by weight of a tackifier and 10 to 1200 parts by weight of a thermally conductive filler.
(2) A composition comprising 100 parts by weight of a rubber, 1 to 1500 parts by weight of a wax or softener, 0 to 1000 parts by weight of a tackifier and 10 to 1200 parts by weight of a thermally conductive filler.
(3) A composition comprising 100 parts by weight of a wax, 0 to 1000 parts by weight of a tackifier and 10 to 1200 parts by weight of a thermally conductive filler.

The compositions (1) to (3) comprise, for example, the following components.

The thermoplastic resin to be used is at least one resin selected from the group consisting of ethylene-vinyl acetate copolymer, polyethylene, atactic polypropylene, ethylene-ethyl acrylate copolymer, polyamide and polyester, and has a softening point of 45 to 120° C. Such thermoplastic resins are, for example, those for use in hot-melt adhesive compositions.

The rubber to be used is at least one rubber selected from the group consisting of polyisoprene rubber, SBR and polybutadiene rubber.

The wax to be used is at least one member selected from the group consisting of paraffin wax, microcrystalline wax, low-molecular-weight polyethylene wax, higher alcohol and higher fatty acid ester.

The thermally conductive composition (1) or (2) is adjustable in softening point by varying the amount of wax to be added to the thermoplastic resin or rubber serving as the base polymer.

The softener to be used is at least one agent selected from the group consisting of vegetable softeners, mineral oil softeners and synthetic plasticizers. Examples of useful vegetable softeners are cottonseed oil, linseed oil, rapeseed oil, pine tar, etc. Examples of useful mineral oil softeners are paraffin, naphthene and aromatic softeners, etc.

Examples of useful synthetic plasticizers are dioctyl phthalate, dibutyl phthalate, dioctyl adipate, isodecyl adipate, dioctyl sebacate, dibutyl sebacate, and the like.

The tackifier to be used is at least one member selected from the group consisting of rosin, rosin derivatives, pinene resins, pentenes, isoprene, 1,3-butadiene, styrenes, indenes and coumarone-indene resins. Preferably the tackifier to be used is compatible with the thermoplastic resin, rubber or wax serving as the base polymer. Incidentally, there are two cases: one wherein no tackifier is incorporated into the thermally conductive compositions (1) to (3), and the other wherein up to 1000 parts by weight of the tackifier is positively incorporated into the compositions.

The thermally conductive filler to be used is at least one compound selected from the group consisting of nitrides, carbides and basic metallic oxides. Examples of useful nitrides are aluminum nitride, boron nitride, silicon nitride, etc. Examples of useful carbides include silicon carbide, titanium carbide and boron carbide. Examples of useful oxides are basic metallic oxides such as aluminum oxide, magnesium oxide, zinc oxide, calcium oxide and zirconium oxide. These fillers are used singly, or in the form of a mixture of at least two of them. The thermally conductive filler to be used is in the form of spherical particles or flaky particles, and is preferably in the range of 0.5 to 100 μm, more preferably in the range of 1 to 10 μm, in mean particle size.

The thermally conductive compositions (1) to (3) may have further incorporated therein a thermal storage material in an amount of up to 30 wt. % based on the composition. Examples of useful thermal storage materials include those of the paraffin, nitric acid salt, acetic acid salt and thiosulfuric acid salt types. These materials are used singly, or in the form of a mixture of at least two of them.

The thermally conductive compositions (1) to (3) are each a gel at room temperature or a sol at a high temperature of 35 to 100° C, and the gel-sol change is reversible. The composition becomes a sol also when dispersed in a suitable dispersion medium. Accordingly, the composition may be converted to a sol by being heated or dispersed in the dispersion medium before printing for forming the thermally conductive film 4. After printing, the film gels when the temperature thereof drops to ordinary temperature or upon evaporation of the dispersion medium.

It is desired that the thermally conductive composition (1), (2) or (3) be 50 to 50000000 cP in viscosity when converted to a sol by heating. If the viscosity is lower than 50 cP, the composition has excessive flowability to flow to the neighboring area, failing to produce a print of predetermined shape. When exceeding 50000000 cP in viscosity, the composition exhibits poor flowability and encounters difficulty in printing.

Usable for applying the composition sol by printing are, for example, the screen printing, roll coating, ink jet printing and doctor blade printing processes.

EXAMPLES

The invention will be described below in detail with reference to a specific example and comparative examples.

Example

To 100 parts by weight of paraffin wax were added 100 parts by weight of finely divided aluminum oxide, 5 μm in mean particle size, and 30 parts by weight of sodium thiosulfate pentahydrate, and the mixture was kneaded with heating to prepare a thermally conductive composition. This composition (100 parts by weight) was dispersed in 30 parts by weight of xylene to obtain a sol.

The sol was then applied to the flat surface 2a of plate body 2 of a heat sink 1 as shown in FIG. 1 by the screen printing process using a screen having a thickness of 30 μm and prepared from nylon yarns, 15 μm in diameter, to form a thermally conductive film 4 measuring 25 mm × 25 mm (see FIG. 1) and to prepare a sample. The film 4 was 25 μm in thickness when dried. In this way, five samples were prepared.

Comparative Example 1

A thermally conductive composition was prepared in the same manner as in Example above and dispersed in an amount of 100 parts by weight in 30 parts by weight of xylene to obtain a sol. The sol was then applied to glass cloth by dipping and thereafter dried to prepare a thermally conductive sheet, 25 μm in thickness and 25 mm × 25 mm in size.

The sheet was affixed to the flat surface 2a of plate body 2 of a heat sink 1 to obtain a sample. In this way, five samples were prepared.

Comparative Example 2

To 100 parts by weight of a liquid silicone elastomer, SH-4 (product of Toray-Dow Corning Silicone Co., Ltd.)

was added 30 parts by weight of finely divided aluminum oxide, 5 μm in mean particle size, and the materials were mixed together to obtain a thermally conductive grease. The grease was applied to the flat surface 2a of plate body 2 of a heat sink 1 to form a coating, 10 μm in thickness and 25 mm × 25 mm in size and to prepare a sample. In this way, five samples were prepared.

Evaluation Test

With reference to FIG. 2, the heat sink 1 was placed on a printed circuit board 5, with the thermally conductive film 4, thermally conductive sheet or grease coating in contact with an integrated circuit 6, and fixed to the circuit board 5 with an unillustrated clip. Although not shown, the integrated circuit 6 was provided with a temperature measuring resistor, and the heat sink 1 with a thermocouple for measuring the temperature of the portion of its plate body 2 immediately above the integrated circuit 6.

The integrated circuit 6 was then caused to generate heat so that the quantity Q of heat generated was 30 W, and the temperature Th of the integrated circuit 6 and the temperature Ti of the plate body 2 were measured while sending a stream of air to radiating fins 3 longitudinally thereof by a fan 7. Based on the measurements of these temperatures Th and Ti, the thermal resistance ($^\circ$ C/W) between the integrated circuit 6 and the plate body 2 was calculated from the equation $R = (Th - Ti)/Q$.

Table 1 shows the results obtained.

Table 1

| | Thermal resistance R ($^\circ$ C/W) | | | | | | Handliability |
|---|---|---|---|---|---|---|---|
| | Sample | | | | | Av. | |
| | 1 | 2 | 3 | 4 | 5 | | |
| Example | 0.03 | 0.03 | 0.04 | 0.03 | 0.03 | 0.03 | Good |
| Comp.Ex.1 | 0.05 | 0.03 | 0.04 | 0.06 | 0.03 | 0.04 | Good |
| Comp.Ex.2 | 0.03 | 0.02 | 0.02 | 0.03 | 0.02 | 0.02 | Poor |

Furthermore, observation was made of the thermally conductive films 4 of the samples of Example and the thermally conductive sheets of the samples of Comparative Example 1.

Table 1 reveals that Example is smaller than Comparative Example 1 in thermal resistance R and less in variations, and that Example is superior to Comparative Example 2 in handliability. In appearance, the thermally conductive films 4 of the samples of Example were free from air, whereas some of the thermally conductive sheets of samples of Comparative Example 2 permitted presence of air.

Table 1 also shows the handliability of the heat sinks 1.

**Claims**

1. A thermally conductive composition for forming a thermally conductive film on a heat sink for use in an electronic device for releasing the heat generated by an electronic component of the device, the composition comprising 100 parts by weight of a thermoplastic resin, 1 to 1500 parts by weight of a wax or softener, 0 to 1000 parts by weight of a tackifier and 10 to 1200 parts by weight of a thermally conductive filler, the composition being a gel at room temperature or a sol at a high temperature of 35 to 100$^\circ$ C and being reversibly convertible in state.

2. A thermally conductive composition according to claim 1 wherein the thermoplastic resin is at least one resin selected from the group consisting of ethylene-vinyl acetate copolymer, polyethylene, atactic polypropylene, ethylene-ethyl acrylate copolymer, polyamide and polyester, and has a softening point of 45 to 120$^\circ$ C.

3. A thermally conductive composition according to claim 1 wherein the wax is at least one member selected from the group consisting of paraffin wax, microcrystalline wax, low-molecular-weight polyethylene wax, higher alcohol and higher fatty acid ester.

4. A thermally conductive composition according to claim 1 wherein the softener is at least one agent selected from the group consisting of vegetable softeners, mineral oil softeners and synthetic plasticizers.

**5.** A thermally conductive composition according to claim 1 wherein the tackifier is at least one member selected from the group consisting of rosin, rosin derivatives, pinene resins, pentenes, isoprene, 1,3-butadiene, styrenes, indenes and coumarone-indene resins and has compatibility with the thermoplastic resin.

**6.** A thermally conductive composition according to claim 1 wherein the thermally conductive filler is at least one compound selected from the group consisting of nitrides, carbides and basic metallic oxides and has a mean particle size of 0.5 to 100 μm.

**7.** A thermally conductive composition according to claim 1 which has a viscosity of 50 to 50000000 cP when converted to a sol by heating.

**8.** A thermally conductive composition for forming a thermally conductive film on a heat sink for use in an electronic device for releasing the heat generated by an electronic component of the device, the composition comprising 100 parts by weight of a rubber, 1 to 1500 parts by weight of a wax or softener, 0 to 1000 parts by weight of a tackifier and 10 to 1200 parts by weight of a thermally conductive filler, the composition being a gel at room temperature or a sol at a high temperature of 35 to 100° C and being reversibly convertible in state.

**9.** A thermally conductive composition according to claim 8 wherein the rubber is at least one rubber selected from the group consisting of polyisoprene rubber, SBR and polybutadiene rubber.

**10.** A thermally conductive composition according to claim 8 wherein the wax is at least one member selected from the group consisting of paraffin wax, microcrystalline wax, low-molecular-weight polyethylene wax, higher alcohol and higher fatty acid ester.

**11.** A thermally conductive composition according to claim 8 wherein the softener is at least one agent selected from the group consisting of vegetable softeners, mineral oil softeners and synthetic plasticizers.

**12.** A thermally conductive composition according to claim 8 wherein the tackifier is at least one member selected from the group consisting of rosin, rosin derivatives, pinene resins, pentenes, isoprene, 1,3-butadiene, styrenes, indenes and coumarone-indene resins and has compatibility with the rubber.

**13.** A thermally conductive composition according to claim 8 wherein the thermally conductive filler is at least one compound selected from the group consisting of nitrides, carbides and basic metallic oxides and has a mean particle size of 0.5 to 100 μm.

**14.** A thermally conductive composition according to claim 8 which has a viscosity of 50 to 50000000 cP when converted to a sol by heating.

**15.** A thermally conductive composition for forming a thermally conductive film on a heat sink for use in an electronic device for releasing the heat generated by an electronic component of the device, the composition comprising 100 parts by weight of a wax, 0 to 1000 parts by weight of a tackifier and 10 to 1200 parts by weight of a thermally conductive filler, the composition being a gel at room temperature or a sol at a high temperature of 35 to 100° C and being reversibly convertible in state.

**16.** A thermally conductive composition according to claim 15 wherein the wax is at least one member selected from the group consisting of paraffin wax, microcrystalline wax, low-molecular-weight polyethylene wax, higher alcohol and higher fatty acid ester.

**17.** A thermally conductive composition according to claim 15 wherein the tackifier is at least one member selected from the group consisting of rosin, rosin derivatives, pinene resins, pentenes, isoprene, 1,3-butadiene, styrenes, indenes and coumarone-indene resins and has compatibility with the wax.

**18.** A thermally conductive composition according to claim 15 wherein the thermally conductive filler is at least one compound selected from the group consisting of nitrides, carbides and basic metallic oxides and has a mean particle size of 0.5 to 100 μm.

**19.** A thermally conductive composition according to claim 15 which has a viscosity of 50 to 50000000 cP when converted to a sol by heating.

**20.** A method of forming a thermally conductive film on a heat sink for use in an electronic device for releasing the heat generated by an electronic component of the device, the method being characterized in that a sol comprising a thermally conductive composition according to any one of claims 1 to 19 is applied by printing to the heat sink over a portion thereof to be brought into contact with the electronic component and is thereafter converted to a gel.

**21.** A method of forming a thermally conductive film according to claim 20 wherein the thermally conductive film to be formed is 15 to 150 µm in thickness.

**Fig.1**

**Fig.2**